Europäisches Patentamt

(19) European Patent Office

Office européen des brevets

(11) Numéro de publication: **0 017 084**
A1

## (12) DEMANDE DE BREVET EUROPEEN

(21) Numéro de dépôt: **80101436.6**

(22) Date de dépôt: **19.03.80**

(51) Int. Cl.³: **H 01 L 35/30**
H 01 L 35/32, H 01 L 25/08
F 25 B 21/02, F 25 B 29/00

(30) Priorité: **26.03.79 FR 7907518**

(43) Date de publication de la demande:
**15.10.80 Bulletin 80/21**

(84) Etats Contractants Désignés:
**BE CH DE FR GB IT NL SE**

(71) Demandeur: **COMPAGNIE EUROPEENNE POUR L'EQUIPEMENT MENAGER "CEPEM" Société anonyme dite:**
**12, rue de la Baume**
**F-75008 Paris(FR)**

(72) Inventeur: **Berthet, Michel**
**2, Domaine de Miremont**
**F-91190 Gif Sur Yvette(FR)**

(72) Inventeur: **Kermarrec, Jean-Claude**
**73bis rue Lavoisier**
**F-78140 Velizy-Villacoublay(FR)**

(72) Inventeur: **Ravelet, Robert**
**26 boulevard Diderot**
**F-91120 Palaiseau(FR)**

(74) Mandataire: **Weinmiller, Jürgen et al,**
**Zeppelinstrasse 63**
**D-8000 München 80(DE)**

(54) Dispositif thermoélectrique de transfert de chaleur avec circuit de liquide.

(57) Dans une pompe à chaleur dont des thermoéléments (20, 22) sont disposés en pile (P1) l'un des fluides caloporteurs est liquide et conduit à travers les étages successifs de la pile par un tube métallique continu (10) électriquement résistant et incurvé en forme de U à chaque étage de manière à augmenter la surface d'échange thermique et à faciliter le montage.
Application au chauffage domestique.

EP 0 017 084 A1

./...

Croydon Printing Company Ltd.

FIG.2

Dispositif thermoélectrique de transfert de chaleur avec circuit
de liquide

La présente invention, due aux travaux de MM. Michel BERTHET,
Jean-Claude KERMAREC et Robert RAVELET des Laboratoires de MARCOUSSIS,
Centre de recherches de la Compagnie Générale d'Electricité, concerne
un dispositif thermoélectrique de transfert de chaleur avec circuit
de liquide comportant :

- d'une part au moins une pile d'éléments électriquement non isolants
superposés en bon contact électrique et thermique selon une direction OZ,
cette pile étant formée de plusieurs étages comportant les quatre
éléments suivants :

- un thermoélément d'un premier type transférant la chaleur dans
le sens du courant électrique,

- un conducteur thermique d'un premier type,

- un thermoélément du deuxième type transférant la chaleur dans le
sens inverse du courant électrique,

- et un conducteur thermique d'un deuxième type,

- ce dispositif comportant d'autre part des connexions électriques aux
deux extrémités de la pile pour faire passer un courant électrique
à travers ces éléments en série,

- un premier circuit de fluide pour la circulation d'un premier fluide
caloporteur,

- un deuxième circuit de fluide pour la circulation d'un deuxième
fluide caloporteur liquide, ce circuit étant constitué par un conduit
traversant en série les conducteurs thermiques du deuxième type des
étages successifs de la pile, les tronçons de ce conduit traversant
ces conducteurs étant des tronçons d'échange thermique, et étant
connectés en série par des tronçons de raccordement s'étendant entre
deux étages successifs de la pile,

- et des échangeurs thermiques d'un premier et d'un deuxième types
pour assurer le transfert de chaleur entre la pile et les fluides
circulant dans ce premier et ce deuxième circuit, respectivement,
les échangeurs du premier type comportant les conducteurs thermiques
du premier type, les échangeurs du deuxième type étant constitués
par lesdits tronçons d'échange thermique et les conducteurs thermiques
du deuxième type.

Un tel dispositif comporte des thermoéléments (éléments thermoélectriques) montés entre des conducteurs thermiques associés à des échangeurs chauds parcourus par un fluide chaud et à des échangeurs froids parcourus par un fluide froid.

Les thermoéléments sont de deux types, à savoir les thermoéléments de type P, qui transfèrent la chaleur dans le sens du courant électrique, et les thermoéléments de type N, qui la transfèrent dans le sens inverse du courant électrique.

De tels dispositifs peuvent être utilisés pour engendrer un courant électrique continu lorsque les conducteurs thermiques sont maintenus à des températures différentes par le fluide chaud et le fluide froid, ou, au contraire, pour maintenir ces conducteurs thermiques à des températures différentes en vue de chauffer ou de refroidir un fluide par rapport à l'autre en faisant circuler un courant électrique continu dans les thermoéléments. Dans ce cas la chaleur est amenée aux thermoéléments et aux conducteurs thermiques par les échangeurs froids et transférée aux échangeurs chauds.

L'invention s'applique plus particulièrement, mais non exclusivement à ce dernier type de dispositifs, les thermoéléments étant alimentés en courant électrique continu pour entretenir une différence de température entre les conducteurs thermiques. Un tel dispositif, appelé "pompe à chaleur", peut aussi être utilisé à des fins de climatisation en réchauffant ou en refroidissant un fluide à partir de l'atmosphère ambiante.

Pour la construction de dispositifs thermoélectriques, on a déjà proposé de leur faire comporter des piles d'échangeurs chauds et froids, électriquement conducteurs et séparés par des thermoéléments alternativement de types P et N, le courant électrique circulant dans le sens de l'empilement, ce sens étant vertical par exemple. Ces piles verticales sont disposées côte à côte de manière à constituer un ensemble d'allure parallélépipédique dans lequel les plaquettes constituant les thermoéléments sont disposérs dans une succession de plans horizontaux et les échangeurs dans les plans horizontaux intermédiaires. Chaque échangeur est parcouru par l'un des fluides selon une direction horizontale qui n'est pas la même selon qu'il s'agit du fluide froid ou du fluide chaud.

La structure mécanique est prévue pour concilier les impératifs d'étanchéité concernant les circuits de fluide avec la présence de dilatations thermiques différentielles. La réalisation de cette structure est rendue particulièrement délicate par le fait que les thermoéléments connus à base de tellurure de bismuth sont extrêmement fragiles.

Une telle structure est par exemple décrite dans le brevet américain n° 3.626.704 (Coe).

Elle présente divers inconvénients notamment lorsque l'un au moins des fluides chaud et froid est constitué par un liquide. Un circuit de liquide peut être alors constitué par un tube qui traverse des échangeurs à liquide successifs de la pile en série en allant alternativement dans un sens et dans l'autre, par exemple alternativement dans des directions horizontales OY et YO, avec des raccords en C situés alternativement d'un côté et de l'autre de la pile. On appelle échangeur à liquide un échangeur de chaleur qui prend ou donne de la chaleur à un liquide. Deux inconvénients apparaissent alors. Le premier est que, si le circuit de liquide a été constitué préalablement avec un tube convenablement courbé pour lui donner la forme sinueuse convenable, les autres éléments de la pile, notamment les thermoéléments, doivent être introduits à partir des deux côtés de la structure constituée par ce tube sinueux, ce qui complique quelque peu le montage et augmente le prix de revient. Il est d'autre part souvent dangereux, du point de vue de l'étanchéité du circuit de liquide, de constituer celui-ci par une succession de tronçons raccordés par collage ou soudage après la constitution de la pile.

Un deuxième inconvénient se manifeste lorsque plusieurs piles du type précité sont disposées l'une à côté de l'autre, en une rangée selon la direction OY. Des précautions doivent alors en effet être prises pour éviter que les raccords en C de deux piles voisines ne viennent se rencontrer, ce qui provoquerait des courts-circuits électriques si, comme il est généralement souhaitable, les piles successives sont alimentées électriquement en série. Ces précautions se traduisent soit par une distance accrue entre les piles successives, c'est-à-dire par un encombrement accru du dispositif, soit par une complication du montage, c'est-à-dire par un prix de revient augmenté. Un troisième inconvénient tient au fait que, si le tube constituant le circuit

- 4 -

liquide a une section circulaire avec un petit diamètre, la surface d'échange thermique entre l'eau et le tube est trop faible. Si le diamètre est accru l'encombrement de la pile est augmenté. Si on donne au tube une forme aplatie, son prix de revient est augmenté et il résiste mal à l'écrasement lorsque la pile est mise en compression, ce qui est souhaitable pour éviter les fractures des thermoéléments lors des manipulations ou lors des dilatations thermiques différentielles.

On connaît d'autre part, par le brevet français n° 1 430 425, un dispositif thermoélectrique de transfert de chaleur avec circuit liquide dans lequel le circuit de liquide comporte des tubes rectilignes traversant en série plusieurs piles d'une même rangée.

Chaque charge de chaque pile comporte un thermoélément (par exemple P) un échangeur (froid), un thermoélément (N) et un échangeur (chaud). A l'extrémité de la rangée le tube rectiligne se raccorde, par un tronçon de raccordement en forme de V, à un autre tube rectiligne traversant en série les piles d'une autre rangée. Le montage d'un tel dispositif est difficile, et les déformations de chaque pile se transmettent aux piles voisines, ce qui risque d'entraîner des fractures des thermoéléments.

La présente invention a pour but la réalisation d'un dispositif thermoélectrique de transfert de chaleur avec circuit de liquide permettant un montage facile, un faible encombrement, et un bon échange thermique. Elle a pour objet un dispositif thermoélectrique de transfert de chaleur avec circuit de liquide comportant :

- d'une part au moins une pile d'éléments électriquement non isolants superposés, en bons contacts électrique et thermique selon une direction OZ, cette pile étant formée de plusieurs étages comportant les quatre éléments suivants :
- un thermoélément d'un premier type transférant la chaleur dans le sens du courant électrique,
- un conducteur thermique d'un premier type,
- un thermoélément du deuxième type transférant la chaleur dans le sens inverse du courant électrique,
- et un conducteur thermique d'un deuxième type,

- ce dispositif comportant d'autre part des connexions électriques aux deux extrémités de la pile pour faire passer un courant électrique à travers ces éléments en série,

- un premier circuit de fluide pour la circulation d'un premier fluide caloporteur,

- un deuxième circuit de fluide pour la circulation d'un deuxième fluide caloporteur liquide, ce circuit étant constitué par un conduit traversant en série les conducteurs thermiques du deuxième type des étages successifs de la pile, les tronçons de ce conduit traversant ces conducteurs étant des tronçons d'échange thermique, et étant connectés en série par des tronçons de raccordement s'étendant entre deux étages successifs de la pile,

- et des échangeurs thermiques d'un premier et d'un deuxième types pour assurer le transfert de chaleur entre la pile et les fluides circulant dans ce premier et ce deuxième circuit, respectivement, les échangeurs du premier type comportant les conducteurs thermiques du premier type, les échangeurs du deuxième type étant constitués par lesdits tronçons d'échange thermique et les conducteurs thermiques du deuxième type,

caractérisé par le fait que chaque tronçon d'échangeur thermique est courbé à chaque étage de la pile de manière à entrer dans le conducteur thermique et à en sortir sur une même face de la pile, la direction de sortie YO étant sensiblement opposée à la direction d'entrée OY.

A l'aide des figures schématiques ci-jointes, on va décrire ci-après, à titre non limitatif, comment l'invention peut être mise en oeuvre. Lorsqu'un même élément est représenté sur plusieurs figures il y ait désigné par le même signe de référence.

La figure 1 représente une vue d'ensemble simplifiée des pièces principales d'un dispositif selon un premier mode de réalisation de l'invention, en perspective partiellement coupée. Ce dispositif constituant une pompe à chaleur eau-air et comportant une pile disposée selon une direction OZ verticale.

La figure 2 représente une vue en perspective éclatée d'une partie du dispositif de la figure 1.

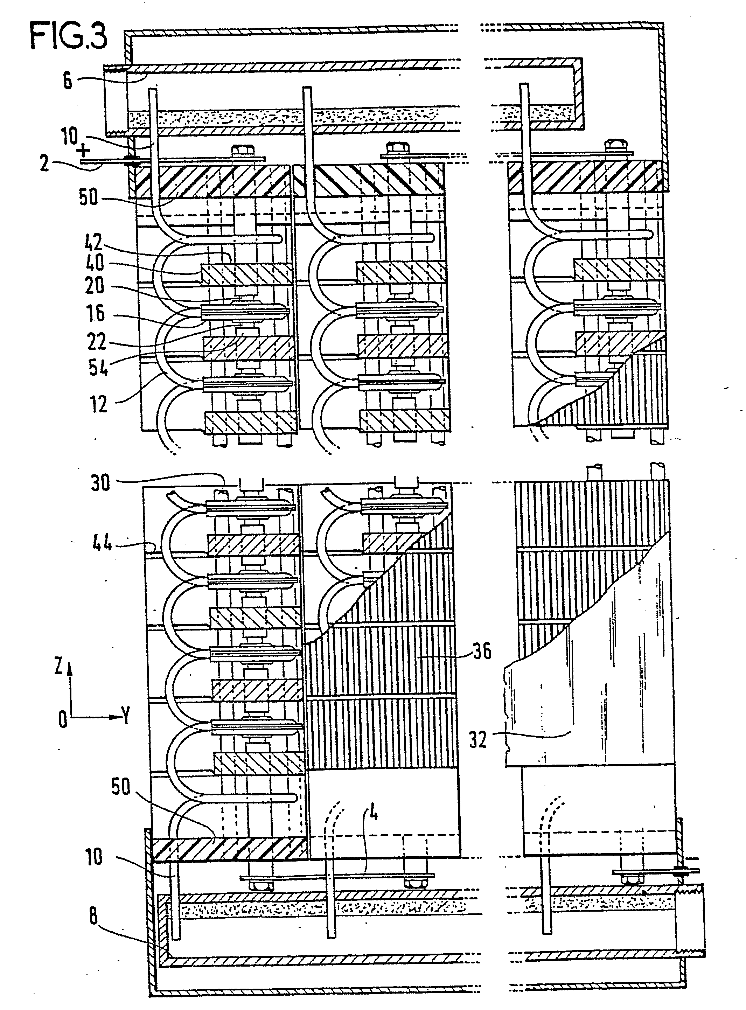

La figure 3 représente une vue du même dispositif en coupe par un plan vertical parallèle à une direction horizontale OY.

La figure 4 représente une vue du même dispositif en coupe par un plan vertical parallèle à une direction horizontale OX perpendiculaire à OY.

La figure 5 représente une vue de dessus d'un échangeur thermique à eau faisant partie du même dispositif.

La figure 6 représente une vue en coupe de l'échangeur de la figure 5, selon un plan VI-VI.

La figure 7 représente une vue en perspective éclatée des pièces principales d'un dispositif selon un deuxième mode de réalisation de l'invention, ce dispositif constituant une pompe à chaleur eau-eau et comportant une pile disposée selon ladite direction OZ.

Les figures 8 et 9 représentent des vues du dispositif de la figure 7 en coupe par deux plans verticaux respectivement parallèles auxdites directions OY et OX.

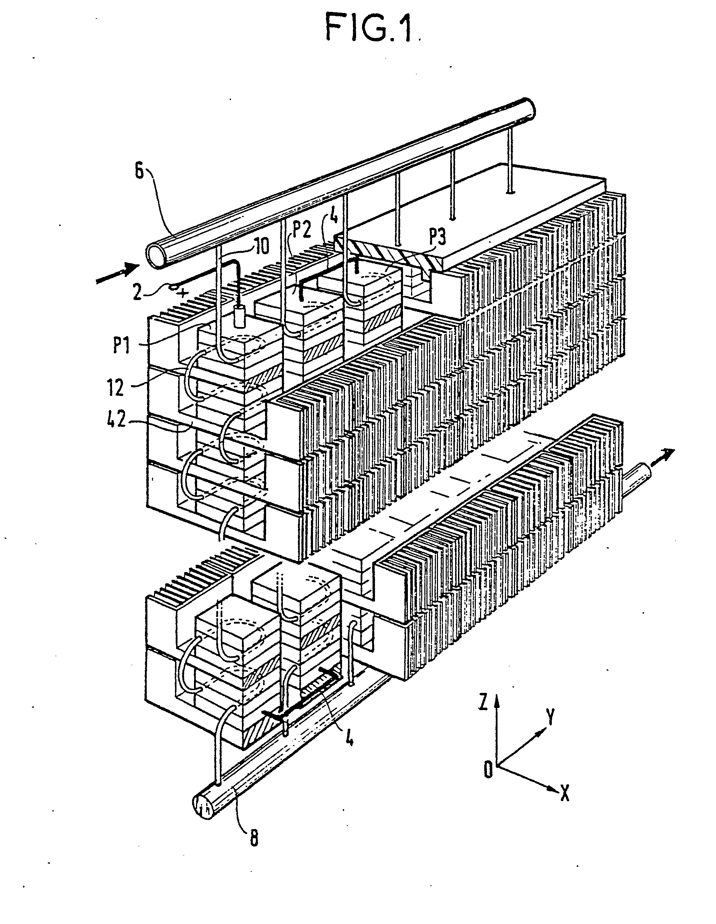

Le premier mode de mise en oeuvre de l'invention fonctionne thermiquement entre un premier fluide qui est l'air et un deuxième fluide qui est l'eau. L'air constitue la source chaude et est chauffé grâce au refroidissement de la source froide constituée par l'eau, c'est-à-dire que le dispositif constitue une pompe à chaleur eau-air. Cette pompe comporte une rangée de piles telles que P1, P2, P3 etc. constituées chacune par un empilement de thermoéléments et de conducteurs thermiques faisant partie d'échangeurs thermiques d'un premier type, à air et d'un deuxième type, à eau. Chaque pile s'élève selon une direction verticale OZ, la rangée s'étendant selon une direction horizontale OY que l'on considèrera par exemple comme allant d'avant en arrière. Conformément à ce qui est représenté sur la figure 1, on peut considérer en première approximation que chaque pile représente la forme d'un prisme vertical à section carrée, deux côtés du carré étant parallèles à OY et deux autres à une direction horizontale OX perpendiculaire à OY que l'on considèrera par exemple comme allant de droite à gauche. Sur cette figure chaque pile présente quatre faces verticales : avant, droite, arrière et gauche. En fait, conformément à ce qui est représenté sur les figures suivantes, les éléments qui composent la pile n'ont pas tous les mêmes dimensions horizontales, celles des thermoéléments étant notamment beaucoup plus petites que celles des échangeurs thermiques, l'axe de la pile étant une ligne verticale passant par les centres de tous les thermoéléments de la pile. Les échangeurs thermiques à air sont les plus larges. Ils comportent chacun une partie qui est située entre les thermoéléments. C'est cette partie intérieure à la pile qui constitue un conducteur thermique du premier type précédemment mentionné.

Chaque étage de la pile comporte un conducteur thermique du premier type faisant partie d'un échangeur thermique à air, un thermoélément d'un premier type P ou N, un conducteur thermique du deuxième type constituant un échangeur thermique à eau et un thermoélément d'un deuxième type opposé au premier.

Trois circuits sont connectés à ces piles à savoir un circuit électrique, un premier et un deuxième circuits de fluides qui sont un circuit d'air et un circuit d'eau.

Le circuit électrique est destiné à faire traverser les thermoéléments par un courant électrique dirigé selon OZ, par exemple, pour les piles de rang pair telles que P2, et selon ZO pour les piles de rang impair telles que P1 et P3. Ces piles sont alimentées successivement en série à partir de deux bornes telles que 2 disposées chacune à une extrémité convenable de l'une des deux piles situées aux deux extrémités de la rangée. Une telle connexion en série permet d'obtenir une impédance acceptable de la pompe à chaleur malgré la faible impédance de chaque pile. Les connexions entre piles sont réalisées par des barrettes telles que 4 disposées alternativement en partie basse et en partie haute.

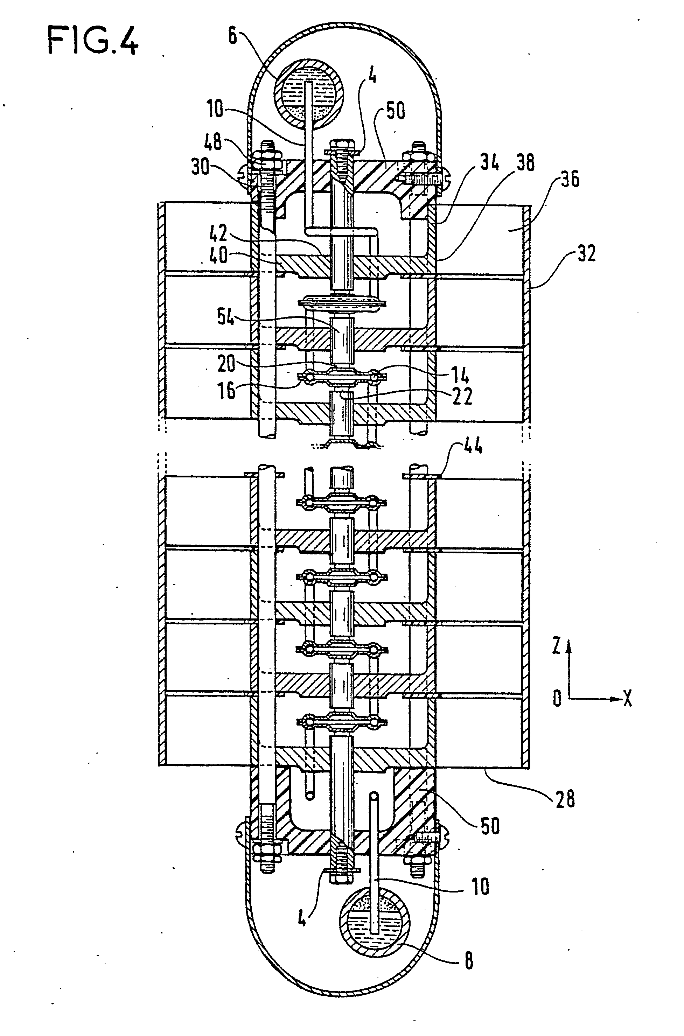

L'ensemble des circuits d'air de la rangée de piles est essentiellement constitué par deux conduits d'air verticaux tels que 28 (voir figure 4) formant deux nappes d'air symétriques à gauche et à droite de la rangée. Il serait évidemment possible mais le plus souvent moins avantageux, qu'il n'y ait qu'un seul conduit par pile, à gauche ou à droite, ou que les conduits correspondants aux diverses piles soient complètement séparés les uns des autres.

Chaque conduit tel que 28 est limité principalement par deux parois verticales parallèles au plan YOZ, une paroi interne 34 non homogène dont la composition sera décrite plus loin, et une paroi
externe 32 par exemple isolante. Il peut être également limité à l'avant
et l'arrière par deux plaques parallèles au plan XOZ et non représentées.

Tout le volume du conduit est occupé par un ensemble de blocs
d'échange thermique tels que 36 constitués par des ailettes verticales
présentant une grande surface d'échange thermique avec l'air, comme
connu. Chacun de ces blocs fait partie d'un échangeur thermique comportant un conducteur thermique à air de la pile. Ces blocs se succèdent
verticalement en regard d'une pile, et horizontalement d'avant en
arrière, en regard des piles successives de la rangée. Ils sont constitués
d'un métal bon conducteur thermique tel que l'aluminium. Ils sont
fixés à la paroi interne 34 par soudure.

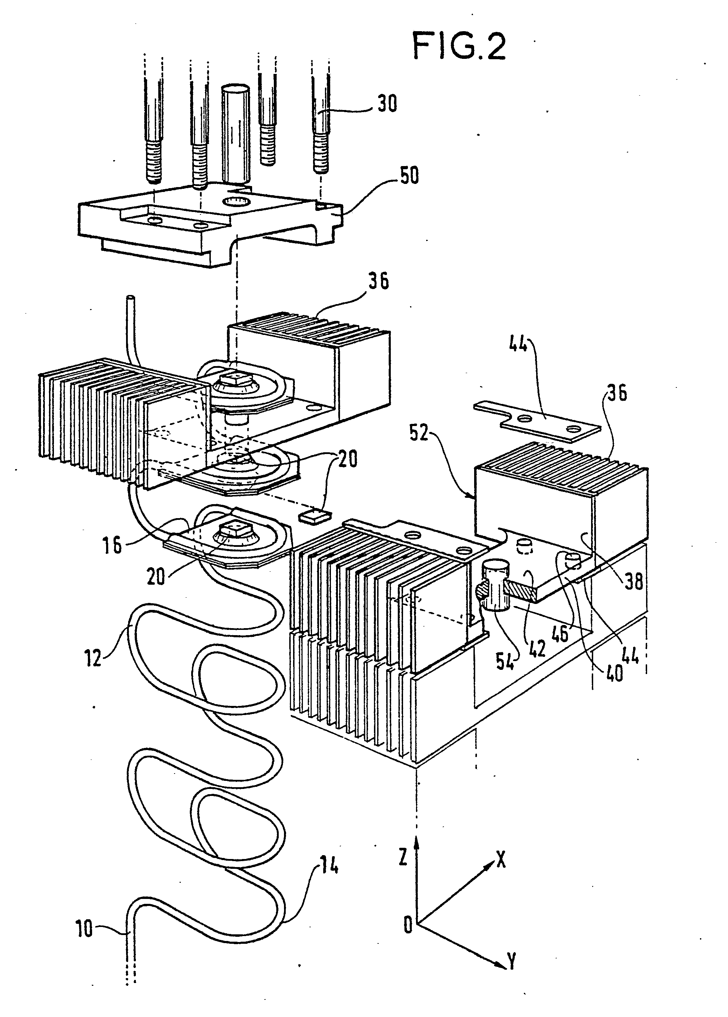

La paroi 34 est constituée par des joues latérales verticales,
telles que 38 formant les extrémités relevées de bras horizontaux
tels que 40 disposés à droite et à gauche, de chaque conducteur thermique à air tel que 54 (voir figures 2 et 4), en bon contact thermique.
Plus particulièrement, ce dernier a la forme d'un cylindre plein vertical
traversant le centre d'une plaque horizontale 42 et soudé à celle-
ci et les deux côtés de cette plaque forment les deux bras 40 à droite
et à gauche. Ces joues 38 présentent la forme de plaques rectangulaires
disposées dans des plans parallèles à YOZ, et ayant des dimensions
telles qu'elles occupent sensiblement toute la surface de la paroi 32.
Pour éviter des courts-circuits électriques, de minces feuilles isolantes
telles que 44 sont disposées entre les bords des plaques adjacentes
constituées par ces joues. Ces feuilles sont maintenues en position
au montage grâce à des perforations qu'elles comportent et qui sont
traversées par des tirants verticaux 30. Ces tirants traversent
aussi les bras 40 par des ouvertures 46 de manière à les maintenir
en place et à appuyer verticalement les joues 38 les unes sur les
autres. Ils sont revêtus d'une gaine isolante pour éviter des courts-
circuits électriques.

Il y a quatre tels tirants autour de chaque pile aux quatre
coins de sa section carrée. Ils sont filetés à leurs extrémités
de manière à permettre, à l'aide d'écrous 48 et de plaques d'appui
isolantes 50, d'assurer au montage une compression efficace qui
est essentiellement supportée par les joues 38, qui constituent ainsi des éléments de compression et forment un empilement. Ceci assure la rigidité de l'ensemble, et permet de maintenir les thermoéléments en compression.

L'ensemble de la plaque 42 avec les deux bras 40 à droite et à gauche, et des deux joues 38 aux extrémités de ces bras constitue une seule pièce 52 faite par exemple d'aluminium nickelé. Cette pièce peut être considérée comme formée de trois plaques qui sont deux plaques verticales parallèles au plan YOZ, c'est-à-dire les deux joues 38, et la plaque de base horizontale 42 réunissant les deux joues. Elle présente vue de l'avant, la forme d'un U, mais pourrait aussi présenter celle d'un I couché. Les joues 38 s'étendent vers l'arrière au-delà de la plaque de base 42 et ménagent entre elles un espace libre occupé partiellement par les tronçons de raccordement d'un conduit d'eau qui sera décrit plus loin. Une telle pièce a deux fonctions : une première fonction est qu'elle constitue un étage d'une colonne de maintien formée par l'empilement de pièces semblables, et coopérant avec les tirants 30 pour réaliser une structure mécanique rigide, solide et facile à monter, chaque étage de cette colonne correspondant à un étage de la pile. La deuxième fonction est de coopérer avec les blocs d'échange thermique 26 pour constituer un échangeur thermique à air à chaque étage de la pile.

Le contact entre les thermoéléments et la pièce 52 est assuré par les cylindres pleins 54 de même matière que cette dernière et disposés dans des orifices percés au centre des plaques 42 en faisant saillie au-dessus et au-dessous.

L'épaisseur de la plaque 42 est par exemple de 6 mm, sa largeur selon OY de 50 mm, sa longueur selon OX de 63 mm, les joues 38 ayant une épaisseur de 2 mm, une hauteur de 24 mm, et une largeur de 50 mm.

Le circuit d'eau comporte un collecteur d'entrée 6 amenant de l'eau tiède (15°C) et un collecteur de sortie 8, emmenant de l'eau refroidie (0°C), ces deux collecteurs étant disposés parallèlement à OY au-dessus et au-dessous de la rangée de piles. Les piles sont alimentées en parallèle entre ces deux collecteurs, chacune par un conduit tel que 10 qui traverse en série tous les conducteurs thermiques pour eau de la pile. L'extrémité inférieure de ce conduit est située sensiblement à la verticale de son extrémité supérieure, mais il présente entre les deux une forme sinueuse complexe constituée par une succession alternée de tronçons de raccordement tels que 12 et de tronçons d'échange thermique tels que 14 (voir figure 2). Chaque tronçon d'échange thermique est disposé dans un plan horizontal, dans un conducteur thermique à eau. Il est courbé de manière à entrer dans le conducteur thermique et à en sortir sur une même face de la pile de la figure 1, cette face étant parallèle au plan XOZ, par exemple la face avant. Il présente dans ce plan horizontal, la forme d'un U dont les branches sont parallèles à la direction OY, une branche étant à droite et l'autre à gauche. Sa section est sensiblement circulaire pour faciliter sa fabrication, et il serait souhaitable, si elle n'était pas circulaire, que sa plus grande dimension transversale soit inférieure au double de la plus petite. Si la plus grande dimension transversale est horizontale cette limitation a pour but d'éviter l'écrasement de ce conduit sous la force de compression verticale qui s'exerce sur la pile, comme il sera expliqué plus loin. Si cette plus grande dimension est verticale cette limitation a pour but d'éviter d'augmenter inutilement la hauteur de la pile.

Chaque tronçon de raccordement présente la forme d'un U dans un plan parallèle à YOZ, les branches du U étant parallèles à OY, l'une au-dessus l'autre au-dessous, en continuité avec les extrémités des tronçons d'échange thermique traversant deux conducteurs thermiques à eau se succèdant dans la pile. Tous les tronçons d'échange thermique se superposent. Les tronçons de raccordement se superposent alternativement dans deux plans parallèles à YOZ, l'un à droite, l'autre à gauche. Les tronçons d'échange thermique doivent présenter une résistance thermique faible à la traversée de leur paroi. Les tronçons de raccordement doivent présenter une résistance électrique longitudinale forte et pourraient dans certains cas être constitués d'un matériau isolant tel que le polychlorure de vinyle. Il a cependant été trouvé préférable d'éviter des collages, coûteux en main d'oeuvre si on veut qu'ils soient certainement étanches, et, pour cela, de constituer l'ensemble du conduit par un seul tube métallique uniforme d'épaisseur de paroi suffisamment faible (inférieure à 0,3 mm), en un métal relativement résistant électriquement et mécaniquement. Ce matériau est l'acier inoxydable. Dans l'exemple décrit l'épaisseur est de 0,1 mm, le diamètre extérieur étant de 2,5 mm. Il semble actuellement difficile de diminuer encore cette épaisseur.

Les tronçons d'échange thermique traversent les conducteurs thermiques à eau, tels que 16 précédemment appelés conducteurs thermiques du deuxième type, et coopèrent avec eux pour constituer des échangeurs thermiques à eau, c'est-à-dire que ces conducteurs thermiques, qui font partie de la pile, transmettent directement la chaleur entre l'eau et les thermoéléments de la pile. Ils pourraient être constitués de diverses manières connues, par exemple, sous la forme de blocs massifs de cuivre traversés par les tronçons d'échange thermique du tube 10. Il a été cependant trouvé préférable de les constituer d'une manière peu coûteuse et, propre à leur conférer une certaine élasticité dans la direction de la pile. Une telle élasticité permet en effet de maintenir facilement la pile en compression sur toute la longueur malgré de petits déplacements longitudinaux qui lui sont imposés de place en place par une structure de maintien rigide qui lui est extérieure et qui subit des dilatations et contractions thermiques, cette structure étant ici constituée par la colonne de maintien précédemment mentionnée et formée par l'empilement des pièces 52 coopérant avec les tirants 30. Une telle compression permanente a pour avantage de diminuer le risque de fracture des thermoéléments, et, si une telle fracture se produit tout de même, de maintenir un contact électrique acceptable à l'endroit de la fracture.

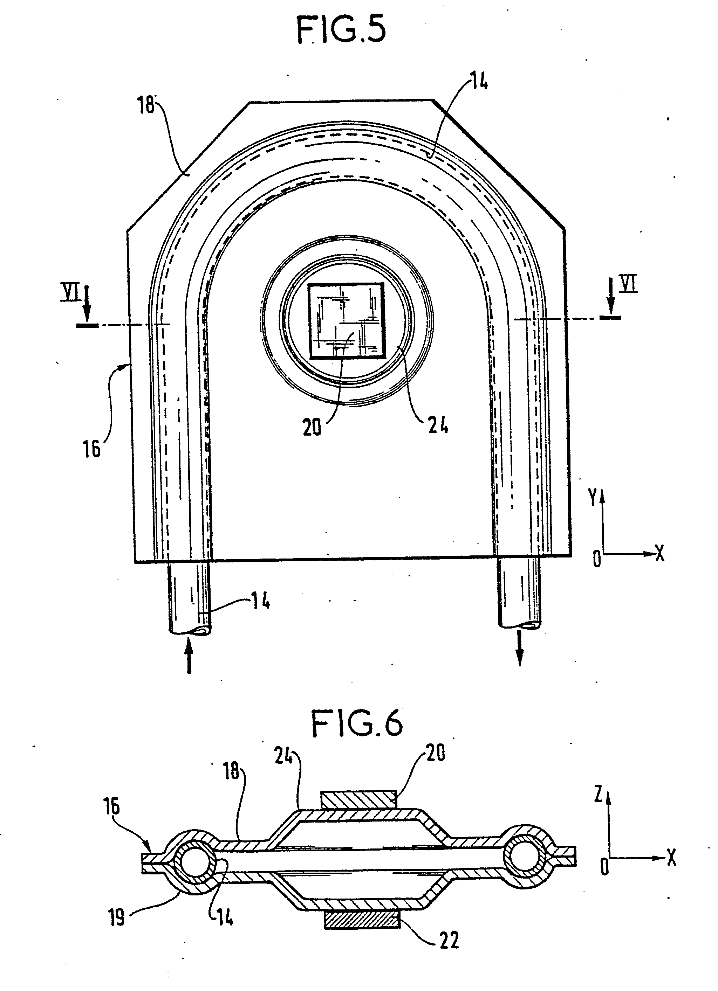

Chaque échangeur thermique à eau est constitué par deux tôles de cuivre (ou d'un autre métal bon conducteur thermique) soudées l'une à l'autre sur une partie de leurs bords et disposées symétriquement de part et d'autre du plan d'un tronçon d'échange thermique 14 auquel elles sont également soudées, de manière notamment à améliorer le contact thermique. On va par exemple décrire surtout la forme de la tôle supérieure 18, la tôle inférieure 19 lui étant identique (voir figures 5 et 6).

Il doit tout d'abord être compris que chaque tronçon d'échange thermique tel que 14 en forme de U fait un demi-tour autour de la zone comprimée de la pile dans laquelle se trouve les thermoéléments tels que 20 et 22, en forme de plaquettes carrées horizontales. Ces plaquettes sont disposées sensiblement à la verticale du centre d'un demi-cercle constituant la base du U. La tôle 18 recouvre le U et en déborde latéralement à droite et à gauche au-delà des branches et vers l'arrière au-delà de la base de manière que le U soit entièrement situé à l'intérieur de la tôle. La tôle 18 est emboutie de manière que sa partie qui déborde du U soit au contact de la tôle 19, dans le plan horizontal médian du tronçon d'échange thermique 14. C'est dans cette partie débordante que ces deux tôles sont soudées l'une à l'autre. Il n'y a ni rapprochement ni soudure des deux tôles sur le bord avant et dans toute la zone située entre les deux branches du U. La tôle 18 est emboutie de manière à s'écarter encore de la tôle 19 et à former une saillie centrale 24 vers le haut dans la zone sur laquelle est soudé le thermoélément 20. C'est l'espace compris entre les deux tôles sous la saillie centrale et jusqu'au tronçon d'échange thermique 14 qui, par flexion de la tôle, confère à l'échangeur thermique une certaine élasticité longitudinale, c'est-à-dire selon la direction OZ, car la liaison mécanique entre les thermoéléments 20 et 22 se fait par l'intermédiaire des tôles 18 et 19 qui ne sont solidarisées que par une partie de leurs bords et par le tronçon d'échange thermique 14.

A titre d'exemple, on peut donner les dimensions suivantes pour l'échangeur thermique à eau :
distance entre les deux branches du U formée par le tronçon d'échange thermique 14 : 23 mm,
- rayon de la saillie centrale 24 : 4 mm,
- épaisseur des tôles 18 et 19 : 0,8 mm,
- distance moyenne maintenue entre les thermoéléments 20 et 22 (épaisseur de l'échangeur) : 6 mm.

Après montage de l'ensemble de la pile et de la colonne de maintien, à l'aide des tirants qui jouent le rôle de guide, on soude en une seule opération les cylindres 54 aux plaques 42, et les thermoéléments 20, 22 à ces cylindres et aux saillies centrales 24 des échangeurs à eau. On met ensuite la colonne de maintien en compression en serrant les écrous 48. L'espace intérieur compris entre les parois 34 est empli d'une mousse isolante polymérisée en place et destinée
à éviter les courts-circuits thermiques.

Il doit être compris que tous les échangeurs thermiques à eau
sont alors en état de compression longitudinale élastique, et ceci
de manière permanente quelles que soient les températures de fonctionnement de la pile. Ceci résulte des conditions créées, lors de
montage, et avant soudure : les cylindres pleins 54 peuvent alors
coulisser légèrement par rapport aux plaques 42, de manière à compenser
les différences de hauteurs des divers éléments par suite des tolérances
de fabrication et assurer la répartition régulière des efforts longitudinaux. D'autre part une pression suffisante est exercée longitudinalement sur l'ensemble de la pile pour créer, dans les échangeurs
thermiques à eau, une déformation élastique supérieure aux différences
maximales de dilatation thermique qui peuvent apparaître ultérieurement
entre la pile et la colonne de maintien. Cette force de pression
est évidemment beaucoup plus faible que celle qui sera exercée ensuite,
après soudure, par serrage des écrous 48, dans le but de rigidifier
la colonne de maintien.

La pompe à chaleur eau-air ainsi réalisée peut être avantageusement utilisée pour le chauffage de l'air d'une pièce d'habitation
à partir d'un circuit d'eau.

Elle peut être associée à divers dispositifs classiques de
chauffage ou de climatisation.

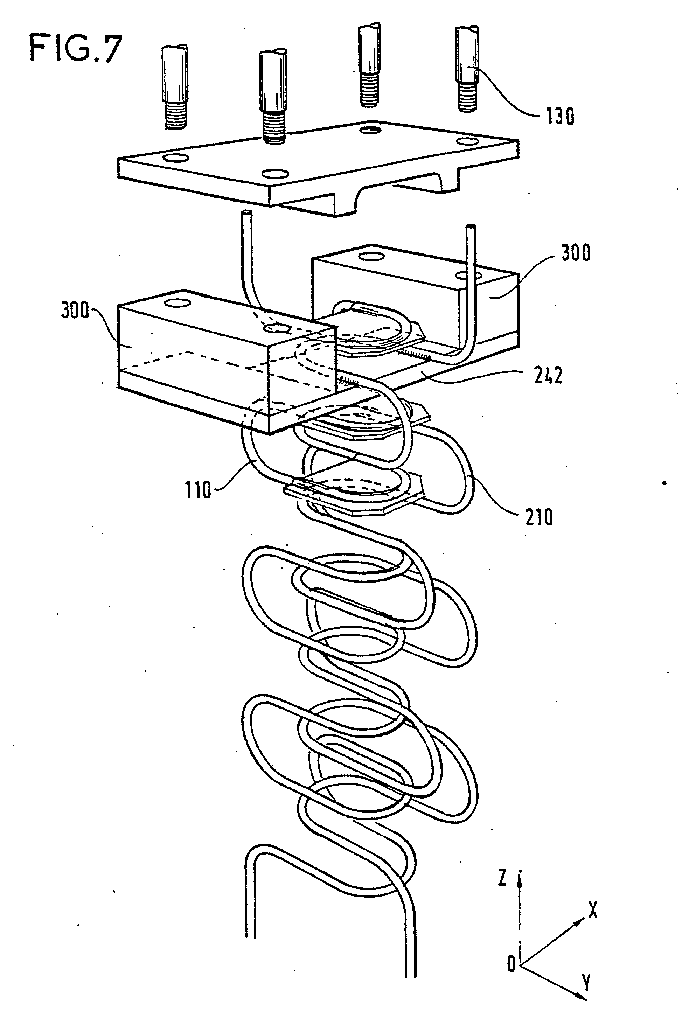

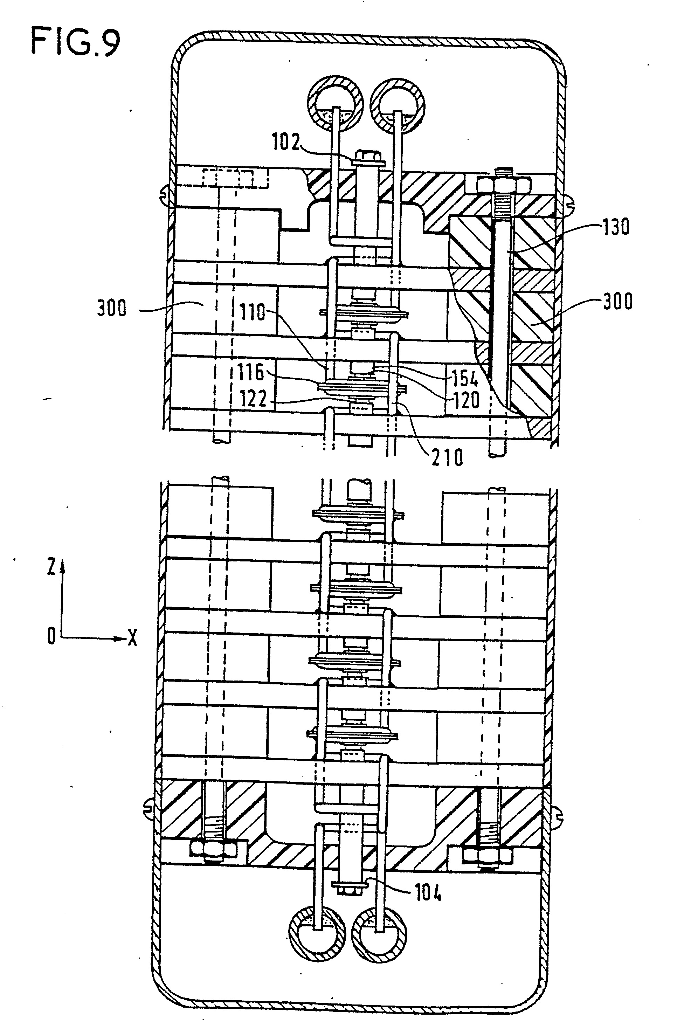

On peut également constituer selon un deuxième mode de réalisation de l'invention, une pompe à chaleur eau-eau représentée très
schématiquement sur les figures 7, 8 et 9. Sauf indication ou évidence
contraires les précisions données à propos des éléments premier mode
de réalisation et de leur disposition sont valables pour les éléments
correspondants du deuxième, qui porte des nombres de référence augmentés
de 100.

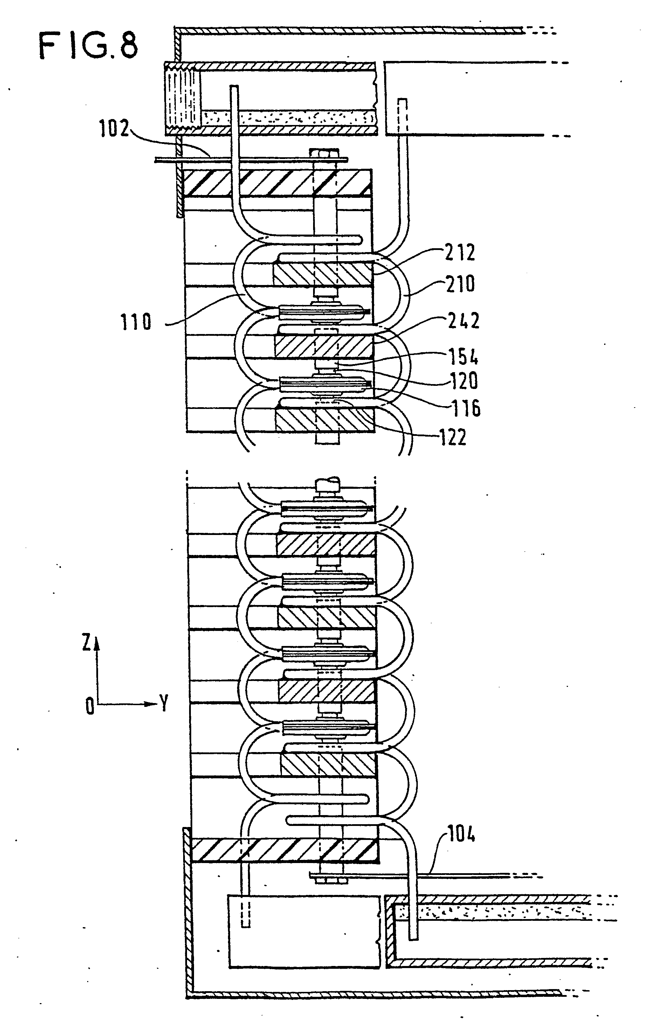

Cette pompe est constituée essentiellement par une pile verticale
(direction OZ) alimentée électriquement par l'intermédiaire de bornes
telles que 102 et 104 (figure 8). Chaque étage de cette pile comporte
un conducteur thermique d'un premier type tel que 154 par exemple
chaud, un thermoélément de type P tel que 120, un conducteur thermique d'un deuxième type tel que 116, par exemple froid, et un thermoélément de type N tel que 122. Chaque conducteur thermique fait partie d'un échangeur de chaleur qui dans le cas de l'échangeur froid est constitué par un conducteur thermique 116 coopérant avec le tube 110 du circuit froid et est identique à l'échangeur 16 coopérant avec le tube 10 du premier mode de réalisation. Quant à l'échangeur chaud il comporte, outre le conducteur 154 identique au conducteur 54 du premier mode de réalisation, une plaque 242, plane et rectangulaire, coopérant avec le conducteur 154 de la même façon que la plaque 42 avec le conducteur 54 dans le premier mode de réalisation. Cette plaque est complètement plane. Elle a deux fonctions: D'abord elle transporte la chaleur entre le conducteur thermique 154 et un tube 210 faisant partie d'un circuit d'eau chaude (premier circuit de fluide). Ce tube est identique au tube 110 sauf qu'il est retourné par symétrie par rapport à un plan XOZ, et décalé en hauteur. Ce tube 210 est soudé, par ses tronçons d'échange thermique sur la plaque 242 de manière à assurer un bon contact thermique.

La plaque 242 constitue d'autre part un élément de liaison avec une colonne de maintien constitué par l'empilement de telles plaques et de blocs de matière plastique 300 servant d'élément de compression et disposés à droite et à gauche des échangeurs 116. L'empilement de ces plaques et de ces blocs est maintenu en compression par quatre tirants verticaux tels que 130 qui traversent ces plaques et ces blocs. Ces tirants sont identiques aux tirants 30 du premier mode de réalisation. Les connexions des deux circuits d'eau sont analogues à celles du circuit d'eau du premier mode de réalisation.

Il est bien clair que d'autres modes de réalisation de l'invention sont encore possibles dans des cas particuliers. Il ne serait par exemple peut être pas nécessaire de donner une élasticité longitudinale à certains des échangeurs à eau si les variations de température de la pile et de la colonne de maintien restaient toujours très faibles.

REVENDICATIONS

1/ Dispositif thermoélectrique de transfert de chaleur avec circuit de liquide comportant :
- d'une part au moins une pile (P1) d'éléments électriquement non isolants superposés en bon contact électrique et thermique selon une direction OZ, cette pile étant formée de plusieurs étages comportant les quatre éléments suivants :
- un thermoélément (20) d'un premier type transférant la chaleur dans le sens du courant électrique ;
- un conducteur thermique (54) d'un premier type,
- un thermoélément (22) du deuxième type ; transférant la chaleur dans le sens inverse du courant électrique,
- et un conducteur thermique (16) d'un deuxième type,
- ce dispositif comportant d'autre part des connexions électriques (24) aux deux extrémités de la pile pour faire passer un courant électrique à travers ces éléments en série,
- un premier circuit de fluide (28) pour la circulation d'un premier fluide caloporteur,
- un deuxième circuit de fluide (10) pour la circulation d'un deuxième fluide caloporteur liquide, ce circuit étant constitué par un conduit traversant en série les conducteurs thermiques du deuxième type des étages successifs de la pile, les tronçons de ce conduit traversant ces conducteurs étant des tronçons d'échange thermique (14), et étant connectés en série par des tronçons de raccordement (12) s'étendant entre deux étages successifs de la pile,
- et des échangeurs thermiques d'un premier (54, 42, 40, 38,26) et d'un deuxième (14, 16) types pour assurer le transfert de chaleur entre la pile et les fluides circulant dans ce premier et ce deuxième circuit, respectivement, les échangeurs du premier type comportant les conducteurs thermiques du premier type, les échangeurs du deuxième type étant constitués par lesdits tronçons d'échange thermique et les conducteurs thermiques du deuxième type,
caractérisé par le fait que chaque tronçon d'échangeur thermique (14) est courbé à chaque étage de la pile de manière à entrer dans le conducteur thermique et à en sortir sur une même face de la pile, la direction de sortie YO étant sensiblement opposée à la direction d'entrée OY.

2/ Dispositif selon la revendication 1, caractérisé par le fait que chaque tronçon d'échange thermique du deuxième type présente la forme d'un U dans un plan parallèle à un plan XOY perpendiculaire à la direction OZ,

- chaque tronçon de raccordement présentant la forme d'un U dans un plan parallèle à un plan YOZ.

les branches de ces divers U étant toutes parallèles à la direction OY, et superposées alternativement dans deux plans parallèles au plan YOZ.

3/ Dispositif selon la revendication 2, caractérisé par le fait que les tronçons d'échange thermique sont constitués par un tube métallique dont la plus grande dimension transversale est inférieure au double de la plus petite.

4/ Dispositif selon la revendication 3, caractérisé par le fait que le conduit de liquide est constitué par un tube métallique continu présentant à la fois une résistance thermique radiale suffisamment faible pour permettre un bon échange thermique dans les tronçons d'échange thermique, et une résistance électrique suffisamment forte pour ne pas détourner le courant électrique.

5/ Dispositif selon la revendication 4, caractérisé par le fait que ledit tube métallique est constitué d'acier inoxydable avec une épaisseur de paroi inférieure à 0,3 mm.

6/ Dispositif selon la revendication 2, caractérisé par le fait qu'il comporte selon la direction OY, une rangée de dites piles chaque dit tronçon de raccordement raccordant deux étages successifs d'une même pile.

# FIG.1

FIG.2

FIG.3

FIG.4

0017084

## FIG.5

## FIG.6

FIG.7

130

300

300

242

110

210

Z

X

0

Y

FIG.8

FIG.9

**Office européen des brevets**

**RAPPORT DE RECHERCHE EUROPEENNE**

Numéro de la demande

EP 80 10 1436

| Catégorie | Citation du document avec indication, en cas de besoin, des parties pertinentes | Revendication concernee |
|---|---|---|
| | **DOCUMENTS CONSIDERES COMME PERTINENTS** | |
| | US - A - 3 178 895 (WESTINGHOUSE)<br>* Figure 1; colonne 5, ligne 8 - colonne 6, ligne 24 * | 1,3-5 |
| | -- | |
| D | FR - A - 1 430 425 (ELFUING)<br>* Figures 5A,5B,6,7; résumé III $1^0$-$3^0$,$9^0$ * | 1-4 |
| | ---- | |

**CLASSEMENT DE LA DEMANDE (Int. Cl. 3)**

H 01 L 35/30
        35/32
        25/08
F 25 B 21/02
        29/00

**DOMAINES TECHNIQUES RECHERCHES (Int. Cl. 3)**

H 01 L 35/30
        35/32
        25/08
F 25 B 21/02
        29/00
F 24 J  3/04

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cite pour d'autres raisons

&: membre de la même famille, document correspondant

Le présent rapport de recherche a été établi pour toutes les revendications

| Lieu de la recherche | Date d'achevement de la recherche | Examinateur |
|---|---|---|
| La Haye | 03-07-1980 | DE RAEVE |

OEB Form 1503.1 06.78